# EUROPÄISCHE PATENTSCHRIFT

(11) **EP 1 273 924 B1**
(45) Veröffentlichungstag und Bekanntmachung des Hinweises auf die Patenterteilung: **18.04.2007**
(21) Anmeldenummer: 02014390.5
(22) Anmeldetag: 28.06.2002
(51) Int. Cl.: G01R 31/04

(54) **Vorrichtung zur Erkennung elektrisch leitfähiger Verunreinigungen auf der Anschlussseite eines elektrischen Verbinders**
Device for the detection of electrically conducting contamination of the contact side of an electric connector
Appareil de détection des contaminations électriquement conductrices du côté contact d'un connecteur

(30) Priorität: 07.07.2001 DE 10133173
(43) Veröffentlichungstag der Anmeldung: 08.01.2003
(73) Patentinhaber: ROBERT BOSCH GMBH, 70442 Stuttgart (DE)
(72) Erfinder: Elter, Stephan, 74076 Heilbronn (DE)

(56) Entgegenhaltungen:
- DE-B- 1 271 846
- US-A- 4 218 653
- US-A- 4 922 183
- PATENT ABSTRACTS OF JAPAN vol. 006, no. 148 (P-133), 7. August 1982 (1982-08-07) & JP 57 069263 A (MATSUSHITA ELECTRIC WORKS LTD), 27. April 1982 (1982-04-27)

## Beschreibung

### Stand der Technik

Die Erfindung betrifft eine Vorrichtung zur Erkennung elektrisch leitfähiger Verunreinigungen auf der Anschlußseite eines elektrischen Verbinders nach dem Oberbegriff des Anspruchs 1.

Die Druckschrift DE 1271846 offenbart einen solchen Verbinder.

Elektrisch leitfähige Verunreinigungen auf der Anschlußseite eines elektrischen Verbinders können bewirken, daß die dort angeordneten Kontaktelemente des Verbinders, beispielsweise von der Anschlußseite abstehende Steckerstifte, elektrisch miteinander verbunden werden, was Fehlfunktionen des an den Verbinder angeschlossenen Gerätes zur Folge haben kann. Handelt es sich bei dem Gerät beispielsweise um ein elektronisches Steuergerät in einem Kfz, das über einen Verbinder an einen Sensor angeschlossen ist, wobei über die Kontaktelemente des Verbinders dem Steuergerät Signalströme des Sensors übermittelt werden, so können beispielsweise Wasserablagerungen auf der Anschlußseite des Verbinders und eine dadurch verursachte elektrische Leitungsverbindung zwischen zwei oder mehr signalführenden Kontaktelementen eine Signalverfälschung zur Folge haben, die vom Steuergerät nicht erkannt wird und Fehlfunktionen desselben bedingt.

Derartige Verunreinigungen des Verbinders werden von einem an den Verbinder angeschlossenen Gerät erst erkannt, wenn ein ankommendes Signal aufgrund seiner starken Verfälschung nicht mehr verarbeitet werden kann und als Fehlsignal identifiziert wird. Geringfügige Signalverfälschungen werden jedoch oft als solche nicht erkannt und statt dessen als reguläre Signale interpretiert und weiterverarbeitet. Schwerwiegende Fehlfunktionen des an den Verbinder angeschlossenen Gerätes sind daher nicht ausgeschlossen.

### Vorteile der Erfindung

Bei der erfindungsgemäßen Vorrichtung zur Erkennung von elektrisch leitfähigen Verunreinigungen auf der Anschlußseite eines Verbinders mit den Merkmalen des Anspruchs 1 der Anmeldung ist eine starke Signalverfälschung zur Erkennung einer Verunreinigung des Verbinders nicht erforderlich. Vorteilhaft wird eine Verunreinigung auf der Anschlußseite des Verbinders als solche erkannt, bevor durch die Verunreinigung Signalströme verfälscht werden. Hierzu befindet sich auf der Anschlußseite des Verbinders eine auf einem Referenzpotential befindliche Leiterstruktur, welche gegenüber den Kontaktelementen durch eine Aussparung in der Leiterstruktur isoliert ist. Bevor nun im Verunreinigungsfall zwei signalführende Kontaktelemente miteinander verbunden werden, wird die Verunreinigung zunächst die beiden Aussparungen überbrücken müssen, durch welche die betroffenen Kontaktelemente jeweils von der Leiterstruktur elektrisch getrennt sind. Somit entsteht zunächst ein elektrischer Kontakt zwischen wenigstens einem der betroffenen Kontaktelemente und der auf der Anschlußseite vorgesehenen Leiterstruktur. In Folge davon fließt Strom von der an eine Referenzspannungsquelle angeschlossenen Leiterstruktur über die Verunreinigung auf das betroffene Kontaktelement. Dieser Stromfluß wird von einer Überwachungseinrichtung erkannt, welche ein entsprechendes Signal ausgibt.

Vorteilhafte Ausführungsbeispiele und Weiterbildungen der Erfindung werden durch die in den Unteransprüchen enthaltenen Merkmale ermöglicht.

Besonders vorteilhaft ist eine elektronische Überwachungseinrichtung, welche einen zwischen die Leiterstruktur und die Referenzspannungsquelle geschalteten Referenzwiderstand sowie elektronische Auswertemittel zur Ermittlung der am Referenzwiderstand abfallenden Spannung und zur Erzeugung eines Erkennungssignals in Abhängigkeit von den übermittelten Spannungswerten aufweist.

Vorteilhaft ist ein Ausführungsbeispiel, bei dem die Referenzspannungsquelle mit einem an der Anschlußseite des Verbinders befindlichen Referenzkontaktelement elektrisch verbunden ist, das wiederum mit der Leiterstruktur elektrisch verbunden ist. Wird das elektrische Gerät über den Verbinder an den komplementären Verbinder eines weiteren Gerätes angeschlossen, so wird das Referenzkontaktelement zusammen mit den übrigen Kontaktelementen des Verbinders mit entsprechenden Gegenkontaktelementen des komplementären Verbinders kontaktiert, wobei das Referenzkontaktelement an ein diesem zugeordnetes Gegen-Referenzkontaktelement angeschlossen wird. Über das Referenzkontaktelement können daher auch Verunreinigungen auf der Anschlußseite des komplementären Verbinders oder Verunreinigungen eines an das weitere Gerät angeschlossenen dritten Verbinders nachgewiesen werden, falls die Anschlußseite dieser weiteren Verbinder jeweils mit einer an das Gegen-Referenzkontaktelement angeschlossenen eigenen Leiterstruktur versehen sind.

Besonders zuverlässig ist ein Ausführungsbeispiel, bei dem die Leiterstruktur durch eine auf die Anschlußseite des Verbinders großflächig aufgebrachte Metallisierung gebildet wird, wobei um die Kontaktelemente herum ringförmige Ausnehmungen in der Leiterstruktur vorgesehen sind, durch welche die Kontaktelemente von der Leiterstruktur elektrisch isoliert sind.

Weiterhin vorteilhaft ist es, die Referenzspannungsquelle (Vr) und die Überwachungseinrichtung (A1,A2) innerhalb eines an den Verbinder angeschlossenen elektronischen Steuergerätes anzuordnen, da die Überwachungseinrichtung dort in Form eines elektronischen Schaltungsteils leicht eingebaut werden kann.

### Zeichnungen

Ein Ausführungsbeispiel der Erfindung ist in den Zeichnungen dargestellt und wird in der nachfolgenden Beschreibung erläutert.

Es zeigt
Fig. 1 einen schematischen und stark vereinfachten Querschnitt durch einen an ein Steuergerät angeschlossenen Verbinder mit einer auf die Anschlußseite aufgebrachten Leiterstruktur,
Fig. 2 eine Draufsicht auf den Verbinder aus Fig. 1,
Fig. 3 ein Ersatzschaltbild eines Ausführungsbeispiels der elektronischen Überwachungseinrichtung,
Fig. 4 ein Ersatzschaltbild für den Fall, daß keine Verunreinigung des Verbinders vorliegt,
Fig. 5 ein Ersatzschaltbild im Verunreinigungsfall.

### Beschreibung eines Ausführungsbeispiels

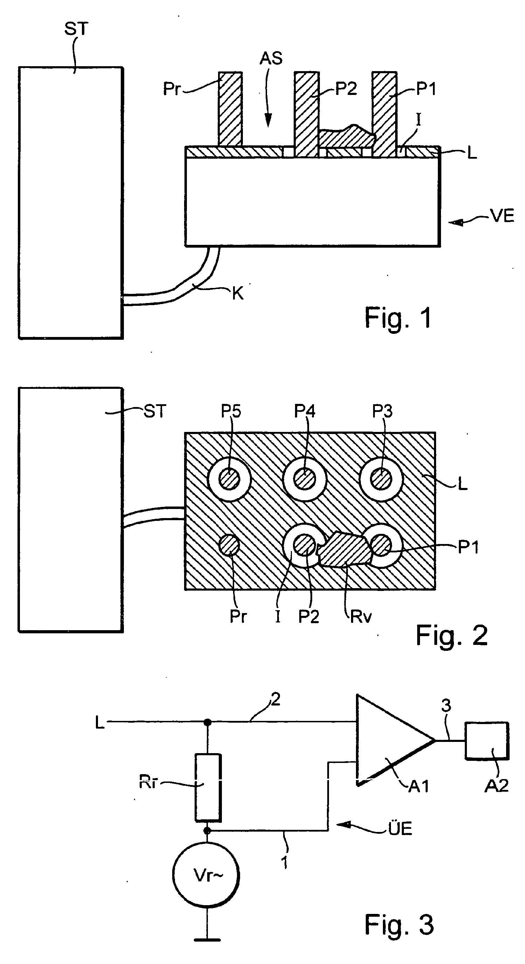

Fig. 1 und Fig. 2 zeigen einen elektrischen Verbinder VE, der beispielsweise über einen Kabelbaum K an ein elektronisches Steuergerät ST angeschlossen ist. Der Verbinder VE weist beispielsweise fünf Kontaktelemente P1-P5 in Form von Steckerstiften auf, welche von einer Anschlußseite AS des Verbinders senkrecht abstehen. Zum Anschluß des Steuergerätes ST an beispielsweise eine Sensoreinrichtung wird der Verbinder VE in einen nicht dargestellten komplementär ausgebildeten Verbinder eingesteckt. Signale der Sensoreinrichtung werden dem Steuergerät ST über die Kontaktelemente P1 bis P5 übermittelt.

Wie in Fig. 1 und Fig. 2 weiterhin zu erkennen ist, ist die Anschlußseite AS des Verbinders VE mit einer Leiterstruktur L in Form einer großflächigen Metallisierung bedeckt, welche zum Beispiel durch Aufdampfen von Kupfer oder Gold hergestellt ist. Die Leiterstruktur L weist kreisförmige Aussparungen I auf, durch welche die Leiterstruktur von den Kontaktelementen P1-P5 elektrisch isoliert ist. Auch andere Geometrien der Aussparungen sind möglich. Zusätzlich kann in die Aussparungen I ein Isolierstoff eingebracht sein, der diese auffüllt. Dies ist aber nicht zwingend erforderlich. Es ist zweckmäßig, die Aussparungen I möglichst klein zu gestalten, so daß die Leiterstruktur L nur durch einen kleinen Spalt von den Kontaktelementen beabstandet ist. An die Leiterstruktur L ist eine Referenzspannungsquelle Vr angeschlossen. Die Referenzspannungsquelle kann vorteilhaft in dem Steuergerät ST angeordnet sein und über den Kabelbaum K mit der Leiterstruktur kontaktiert werden. Von der Anschlußseite AS des Verbinders VE steht ein weiterer Steckerstift Pr ab, welcher als Referenzkontaktelement vorgesehen ist und direkt mit der Leiterstruktur L elektrisch leitend verbunden ist, wie in Fig. 2 gut zu erkennen ist. Das Referenzkontaktelement Pr ist optional und dient der Überwachung einer Verunreinigung auf dem Gegenverbinder des Sensors. Über das Referenzkontaktelement Pr kann aber auch der richtige Anschluß des Verbinders VE an einen komplementären Verbinder überwacht werden. Das Referenzkontaktelement kann aber auch entfallen. Wichtig ist zunächst nur, daß die Leiterstruktur L an die Referenzspannungsquelle Vr angeschlossen ist.

Weiterhin ist eine Überwachungseinrichtung ÜE in dem Steuergerät ST angeordnet, welche aber auch in dem Verbinder VE oder an einem anderen Ort angeordnet werden kann. Die elektronische Überwachungseinrichtung wird beispielsweise durch ein elektronisches Schaltungsteil gebildet. Ein Ersatzschaltbild für ein Ausführungsbeispiel der Überwachungseinrichtung ist in Fig. 3 dargestellt. Zwischen die Referenzspannungquelle Vr und die Leiterstruktur L ist ein elektrischer Referenzwiderstand Rr geschaltet. Die beiden Ausgänge des Referenzwiderstandes Rr sind über Leitungen 1,2 mit einem ersten Auswertemittel A1 in Form eines Differenzverstärkers verbunden, welcher in Abhängigkeit von der am Referenzwiderstand Rr abfallenden Spannung ein Ausgangssignal am Ausgang 3 erzeugt, das der verstärkten Spannungsdifferenz zwischen den Leitungen 1 und 2 entspricht und dem zweiten Auswertemittel A2 übermittelt wird. Das zweite Auswertemittel ist ein elektronisches Schaltungsteil, welches bei Überschreiten eines Spannungshöchstwertes ein Alarmsignal ausgibt.

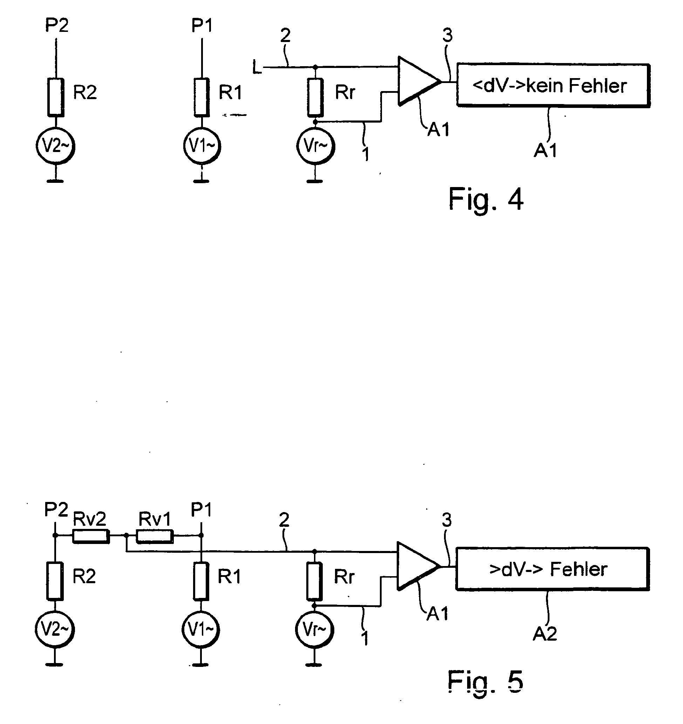

Wird der Verbinder VE des Steuergerätes ST im Betriebsfall an den Gegen-Verbinder des Sensors angeschlossen, so liegen beispielsweise an den Kontaktelementen P1 und P2 die Signalspannungen V1 beziehungsweise V2 an, wie dies in Fig. 4 dargestellt ist. Mit R1 und R2 sind die Innenwiderstände der Signalleitungen bezeichnet. Die Signalspannungen V1, V2 werden dem Steuergerät übermittelt und von diesem verarbeitet. In Fig. 4 ist der Fall gezeigt, daß keine Verunreinigung der Anschlußseite AS vorliegt. Die Referenzspannung Vr liegt an der Leiterstruktur L an, welche elektrisch von den Kontaktelementen P1-P5 isoliert ist. Über den Referenzwiderstand Rr kann kein Strom fließen. Folglich tritt kein Spannungsabfall am Referenzwiderstand Rr auf und das Auswertemittel A2 gibt kein Alarmsignal aus.

Bildet sich nun eine elektrisch leitende Verunreinigung Rv auf der Anschlußseite AS des Verbinders VE, beispielsweise ein Wassertropfen, so tritt der in Fig. 5 dargestellte Fall ein. Die Verunreinigung wird bevor sie beispielsweise die Kontaktelemente P1 und P2 miteinander elektrisch verbindet zunächst den kleinen Spalt zwischen dem Kontaktelement P1 oder dem Kontaktelement P2 und der Leiterstruktur L überbrükken müssen. Der die jeweilige Isolieraussparung I überbrükkende Teil der Verunreinigung stellt einen elektrischen Leiter mit einem Widerstand Rv1 beziehungsweise Rv2 dar. Aufgrund der Verunreinigung fließt von der an die Referenzspannungsquelle Vr angeschlossenen Leiterstruktur L über den Widerstand Rv1 der Verunreinigung ein Strom auf das Kontaktelement P1 und/oder über den Widerstand Rv2 ein Strom auf das Kontaktelement P2. Es ist daher darauf zu achten, daß sich das Signal der Referenzspannungsquelle Vr von den regulären Signalen unterscheidet, welche auf die Kontaktelemente P1 bis P5 übertragen werden, so daß das Signal der Referenzspannungsquelle Vr von der Empfängereinheit erkannt und von regulären Signalen unterschieden werden kann. Der im Verunreinigungsfall fließende Strom fließt durch den zwischen die Referenzspannungsquelle Vr und die Leiterstruktur geschalteten Referenzwiderstand Rr, so daß dort eine Spannung dV abfällt, welche vom Differenzverstärker A1 verstärkt und dem Auswertemittel A2 übermittelt wird. Diese Spannung dV ist um so größer, je größer der elektrische Strom ist, der durch die Verunreinigung fließt. Das Auswertemittel A2 schlägt beispielsweise Alarm sobald der übertragene Spannungswert einen vorgegebenen Vergleichswert für eine bestimmte Zeit überschreitet.

Man erkennt, daß mit der vorgeschlagenen Anordnung der Leiterstruktur L auf der.Anschlußseite des Verbinders VE in jedem Fall erreicht wird, daß spätestens sobald eine elektrisch leitfähige Verunreinigung zwei Kontaktelemente elektrisch verbindet (mit großer Wahrscheinlichkeit jedoch bereits zu einem früheren Zeitpunkt) ein Alarmsignal ausgegeben wird, welches benutzt werden kann, um das Steuergerät abzuschalten, bevor ein fehlerhaftes Signal verarbeitet wird. Somit ist ausgeschlossen, daß die Verunreinigung zu spät erkannt wird und Fehlfunktionen des Steuergerätes verhängnisvolle Folgen haben, was insbesondere für ein in einem Kraftfahrzeug eingesetztes elektronisches Steuergerät von großer Bedeutung ist.

Bei der Wahl des Referenzwiderstandes Rr ist darauf zu achten, daß dieser nicht deutlich kleiner als die Summe aus dem Innenwiderstand der Signalleitung und dem Widerstandswert der Verunreinigung (Rv1,Rv2) sein sollte, da dann die am Referenzwiderstand abfallende Spannung zu klein werden könnte, so daß die elektronischen Auswertemittel A2 nicht ansprechen. Daher sollte der Referenzwiderstand deutlich größer als der Innenwiderstand R1,R2 der Signalleitungen gewählt werden, über welche der Strom von der Referenzspannungsquelle abließt (Rr >> R1,R2). Andererseits sollte der Referenzwiderstand Rr nicht zu groß gewählt werden, um zu vermeiden, daß eine elektromagnetische Störstrahlung, welche über die Leiterstruktur L eingestrahlt wird, zu einem Spannungsabfall am Referenzwiderstand Rr führt und so den Alarmfall auslöst. Das Signal der Referenzspannungsquelle Vr ist selbstverständlich so zu wählen, daß es sich signifikant von allen zu überwachenden regulären Signalen unterscheidet. Die Spannung der Referenzspannungsquelle Vr muß nicht konstant sein und kann sich beispielsweise mit der Zeit ändern. In einem bevorzugten Ausführungsbeispiel liefert die Referenzspannungsquelle eine niederfrequente Sinusspannung oder eine sägezahnförmige Spannung. Dies hat Vorteile, falls die Spannungsversorgung des Steuergerätes ebenfalls über den zu überwachenden Verbinder VE erfolgt. Wird beispielsweise der Plus- und Minuspol der Spannungsversorgung des Steuergerätes durch eine Verunreinigung auf dem Verbinder kurzgeschlossen, können an der Leiterstruktur alle Spannungswerte zwischen dem Spannungspotential des Plus- und dem des Minuspols auftreten. In solchen Fällen wird dann nicht immer zuverlässig ein Fehler erkannt, wenn die Referenzspannungsquelle einen konstanten Spannungswert zwischen den Potentialen des Plus- und des Minuspols liefert. Wird aber eine veränderliche Spannung der Referenzspannungsquelle benutzt, verändert sich ständig die Spannungsdifferenz zwischen der Referenzspannung und den Signalspannungen. So können alle Signale gleich gut überwacht werden.

## Patentansprüche

1. Vorrichtung zur Erkennung elektrisch leitfähiger Verunreinigungen auf einer mit Kontaktelementen (P1,P2...P5) versehenen Anschlußseite (AS) eines elektrischen Verbinders (VE), insbesondere eines elektrischen Verbinders eines elektronischen Steuergerätes, **gekennzeichnet durch** eine auf die Anschlußseite (AS) des Verbinders um die Kontaktelemente (P1,P2...P5) herum aufgebrachte und mit einer Referenzspannungsquelle (Vr) elektrisch verbundene Leiterstruktur (L), die von den Kontaktelementen **durch** jeweils eine Aussparung (I) in der Leiterstruktur isoliert ist, und **durch** eine Überwachungseinrichtung (ÜE), welche bei einer Kontamination der Anschlußseite (AS) mit einer leitfähigen Verunreinigung (Rv), **durch** welche eine der Aussparungen (I) überbrückt wird, einen **dadurch** verursachten Stromfluß zwischen der Leiterstruktur (L) und dem in dieser Aussparung angeordneten Kontaktelement (P1,P2...P5) erkennt und ein entsprechendes Signal ausgibt.

2. Vorrichtung nach Anspruch 1, **dadurch gekennzeichnet, daß** die Überwachungsreinrichtung (ÜE) durch ein elektronisches Schaltungsteil gebildet wird.

3. Vorrichtung nach Anspruch 2, **dadurch gekennzeichnet, daß** die Überwachungseinrichtung einen zwischen die Leiterstruktur (L) und die Referenzspannungsquelle (Vr) geschalteten Referenzwiderstand (Rr) sowie erste elektronische Auswertemittel (A1) zur Ermittlung der am Referenzwiderstand (Rr) abfallenden Spannung und weitere elektronische Auswertemittel (A2) zur Erzeugung eines Warnsignals in Abhängigkeit von den durch die ersten Auswertemittel (A1) übermittelten Spannungswerten aufweist.

4. Vorrichtung einem der vorstehenden Ansprüche 3, **dadurch gekennzeichnet, daß** die Referenzspannungsquelle (Vr) mit einem an der Anschlußseite (AS) angeordneten Referenzkontaktelement (Pr) elektrisch verbunden ist, das wiederum mit der Leiterstruktur (L) elektrisch verbunden ist.

5. Vorrichtung nach einem der vorstehenden Ansprüche, **dadurch gekennzeichnet, daß** die Leiterstruktur (L) durch eine auf die Anschlußseite (AS) des Verbinders (VE) großflächig aufgebrachte Metallisierung gebildet wird, wobei um die Kontaktelemente (P1,P2....P5) herum ringförmige Ausnehmungen (I) in der Leiterstruktur (L) vorgesehen sind, durch welche die Kontaktelemente von der Leiterstruktur elektrisch isoliert sind.

6. Vorrichtung nach einem der vorstehenden Ansprüche, **dadurch gekennzeichnet, daß** sich die Spannung der Referenzspannungsquelle (Vr) in Abhängigkeit von der Zeit ändert und insbesondere eine niederfrequente Sinusspannung ist oder sich sägezahnförmig ändert.

7. Elektronisches Steuergerät (ST) mit einem daran angeschlossenen elektrischen Verbinder (VE) und mit einer Vorrichtung nach einem der vorstehenden Ansprüche, **dadurch gekennzeichnet, daß** die Referenzspannungsquelle (Vr) und die Überwachungseinrichtung (A1,A2) innerhalb des elektronischen Steuergerätes (ST) angeordnet sind.

## Claims

1. Apparatus for detecting electrically conductive contaminants on a connection side (AS) of an electrical connector (VE), in particular of an electrical connector of an electronic control unit, said connection side being provided with contact elements (P1, P2...P5), **characterized by** a conductor structure (L) which is applied to the connection side (AS) of the connector around the contact elements (P1, P2...P5), is electrically connected to a reference voltage source (Vr) and is insulated from the contact elements by means of a respective recess (I) in the conductor structure, and by a monitoring device (ÜE) which; in the event of contamination of the connection side (AS) with a conductive contaminant (Rv) which bridges one of the recesses (I), detects a flow of current, which is caused thereby, between the conductor structure (L) and the contact element (P1, P2...P5) arranged in this recess and outputs a corresponding signal.

2. Apparatus according to Claim 1, **characterized in that** the monitoring device (ÜE) is formed by an electronic circuit part.

3. Apparatus according to Claim 2, **characterized in that** the monitoring device has a reference resistor (Rr), which is connected between the conductor structure (L) and the reference voltage source (Vr), and first electronic evaluation means (A1) for determining the voltage dropped across the reference resistor (Rr), and further electronic evaluation means (A2) for generating a warning signal on the basis of the voltage values transmitted by the first evaluation means (A1).

4. Apparatus according to one of the preceding claims, **characterized in that** the reference voltage source (Vr) is electrically connected to a reference contact element (Pr) which is arranged on the connection side (AS) and is in turn electrically connected to the conductor structure (L).

5. Apparatus according to one of the preceding claims, **characterized in that** the conductor structure (L) is formed by a metallization which is applied to a large area of the connection side (AS) of the connector (VE), annular recesses (I) which electrically insulate the contact elements from the conductor structure being provided around the contact elements (P1, P2...P5) in the conductor structure (L).

6. Apparatus according to one of the preceding claims, **characterized in that** the voltage of the reference voltage source (Vr) changes as a function of time and is, in particular, a low-frequency sinusoidal voltage or changes in sawtooth-shaped fashion.

7. Electronic control unit (ST) having an electrical connector (VE) connected to it and having an apparatus according to one of the preceding claims, **characterized in that** the reference voltage source (Vr) and the monitoring device (A1, A2) are arranged inside the electronic control unit (ST).

## Revendications

1. Dispositif de détection de pollutions électriquement conductrices sur une face de raccordement (AS), ayant des éléments de contact (P1, P2, ... P5), d'un connecteur électrique (VE), en particulier d'un connecteur électrique d'un appareil de commande électronique,
**caractérisé en ce qu'**
une structure conductrice (L) placée sur la face de raccordement (AS) du connecteur autour des éléments de contact (P1, P2, ... P5) est reliée électriquement à une source de tension de référence (Vr), et isolée des éléments de contact par, respectivement, un évidement (I) dans celle-ci, et, en cas de contamination du côté de raccordement (AS) par une pollution conductrice (Rv) provoquant le pontage de l'un des évidements (I), un dispositif de surveillance (ÜE) détecte un flux de courant provoqué par ce pontage entre la structure conductrice (L) et l'élément de contact disposé dans cet évidement (P1, P2, ... P5), et émet un signal correspondant.

2. Dispositif selon la revendication 1,
**caractérisé en ce que**
le dispositif de surveillance (ÜE) est formé d'un élément de commutation électronique.

3. Dispositif selon la revendication 2,
**caractérisé en ce que**
le dispositif de surveillance présente une résistance de référence (Rr) commutée entre la structure conductrice (L) et la source de tension de référence (Vr), ainsi que des premiers moyens d'exploitation électroniques (A) pour déterminer la tension chutant au niveau de la résistance de référence (Rr), et d'autres moyens d'exploitation électroniques (A2) pour générer un signal d'avertissement en fonction des valeurs de tension transmises par les premiers moyens d'exploitation (A1).

4. Dispositif selon l'une quelconque des revendications 3,
**caractérisé en ce que**
la source de tension de référence (Vr) est reliée électriquement à l'élément de contact de référence (Pr) disposé sur la face de raccordement (AS), élément qui, à son tour, est relié électriquement à la structure conductrice (L).

5. Dispositif selon l'une quelconque des revendications précédentes,
**caractérisé en ce que**
la structure conductrice (L) est formée par une métallisation appliquée, sur une grande surface, sur la face de raccordement (AS) du connecteur (VE), et des évidements annulaires (I) prévus dans la structure conductrice (L) autour des éléments de contact (P1, P2, ... P5), isolent électriquement les éléments de contact de la structure conductrice.

6. Dispositif selon l'une quelconque des revendications précédentes,
**caractérisé en ce que**
la tension de la source de tension de référence (Vr) change en fonction du temps,et en particulier, est sinusoïdale à basse fréquence ou en forme de dents de scie.

7. Appareil de commande électronique (ST) comportant un connecteur électrique (VE) qui lui est raccordé et un dispositif selon l'une quelconque des revendications précédentes,
**caractérisé en ce que**
la source de tension de référence (Vr) et le dispositif de surveillance (A1, A2) sont disposés à l'intérieur de l'appareil de commande électronique (ST).
